# FASCICULE DE BREVET EUROPEEN

(11) **EP 4 286 820 B1**
(45) Date de publication et mention de la délivrance du brevet: **05.11.2025**
(21) Numéro de dépôt: 23177022.3
(22) Date de dépôt: 02.06.2023
(51) Int. Cl.: G01M 3/20, G01M 3/38, H05K 7/20

(54) **SYSTÈME DE DÉTECTION DE FUITE DE FLUIDE DE REFROIDISSEMENT DANS UN ÉQUIPEMENT ÉLECTRONIQUE**
SYSTEM ZUR ERKENNUNG VON KÜHLMITTELLECKS IN EINER ELEKTRONISCHEN VORRICHTUNG
SYSTEM FOR DETECTING COOLING FLUID LEAKAGE IN AN ELECTRONIC EQUIPMENT

(30) Priorité: 03.06.2022 FR 2205367
(43) Date de publication de la demande: 06.12.2023
(73) Titulaire: THALES, 92400 Courbevoie (FR)
(72) Inventeur: SOULIER, Paul, 33700 MERIGNAC (FR); PECOUT, David, 33700 MERIGNAC (FR); BERON, Didier, 33700 MERIGNAC (FR)
(74) Mandataire: Lavoix

(56) Documents cités:
- EP-A1- 4 053 543
- WO-A1-2016/103786
- WO-A1-2021/085543
- CN-U- 203 275 050
- US-A1- 2018 172 359

## Description

La présente invention concerne un système de détection de fuite de fluide de refroidissement dans un équipement électronique, adapté pour des équipements électroniques embarqués sur des aéronefs.

L'invention se situe dans le domaine de la maintenance d'équipements électroniques embarqués, en particulier dans des aéronefs.

Les équipements électroniques embarqués sur des aéronefs subissent des conditions extrêmes de température et de pression.

De manière connue, les équipements électroniques embarqués sont montés dans ou sur des circuits qui contiennent un fluide de refroidissement, qui est un fluide caloporteur, dont la fonction est d'évacuer la chaleur produite par le fonctionnement des composants électroniques. L'utilisation d'un fluide de refroidissement est nécessaire pour permettre un bon fonctionnement et éviter tout endommagement des composants électroniques embarqués dans des équipements électroniques.

En général, le fluide de refroidissement est composé d'eau mélangée à un additif, par exemple l'éthylène glycol ou le propylène glycol, permettant d'augmenter sa température d'ébullition et/ou d'augmenter la résistance au gel.

Dans le domaine de l'aéronautique, des spécifications standardisées imposent le respect de diverses caractéristiques à respecter par les fluides de refroidissement utilisés.

De tels fluides de refroidissement sont en général corrosifs, et susceptibles d'endommager les composants électroniques s'ils rentrent en contact direct avec ceux-ci, par exemple dans le cas de la présence de micro-fuites, ce qui peut entraîner des défauts de fonctionnement ou des pannes, et donc un besoin de maintenance. En l'absence de détection de fuite de fluide de refroidissement, il est nécessaire d'effectuer une maintenance après détection de pannes, au sol, sans connaissance effective de la cause de la panne. De plus, une fuite de fluide de refroidissement est difficile, voire impossible, à reproduire au sol, à cause de la difficulté de reproduire des conditions de température et de pression analogues.

Les documents WO2021/085543A1, WO2016/103786A1 et CN 203275050 U décrivent des systèmes de détection de fuite de gaz réfrigérant.

Il existe un besoin de détecter toute fuite de fluide de refroidissement, en particulier en vol.

A cet effet, l'invention propose, selon un aspect, un système de détection de fuite de fluide de refroidissement dans un équipement électronique conforme à la revendication 1.

Avantageusement, le système de détection de fuite de fluide de refroidissement proposé effectue une détection de fuite de fluide de refroidissement par détection d'au moins un composé organique volatil émis par le fluide de refroidissement.

Un mode de réalisation concerne un équipement électronique comportant un boîtier encapsulant au moins un composant électronique et un circuit de refroidissement comportant un fluide de refroidissement, qui comporte, à l'intérieur dudit boîtier, un système de détection de fuite de fluide de refroidissement tel que brièvement décrit ci-dessus.

D'autres caractéristiques et avantages de l'invention ressortiront de la description qui en est donnée ci-dessous, à titre indicatif et nullement limitatif, en référence aux figures annexées, parmi lesquelles :
[Fig 1] la figure 1 représente schématiquement un aéronef équipé d'un système de détection de fuite de fluide de refroidissement;
[Fig 2] la figure 2 représente schématiquement les modules fonctionnels d'un système de détection de fuite de liquide de refroidissement;
[Fig 3] la figure 3 illustre des spectres d'absorption de composants organiques volatils émis par un fluide de refroidissement dans un cas d'application ;
[Fig 4] la figure 4 représente un capteur de détection de fluides de refroidissement selon un mode de réalisation.

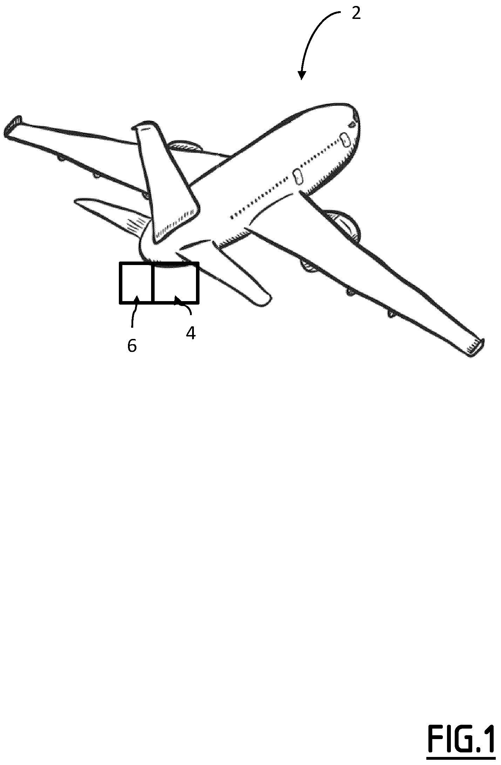

La figure 1 illustre schématiquement un aéronef 2, et un équipement électronique 4 embarqué dans l'aéronef 2.

Il est entendu que la représentation est schématique, en pratiqué un aéronef comportant une pluralité d'équipements électroniques 4 embarqués, par exemple des capteurs, tube à ondes progressives, alimentations, calculateurs de bord, antenne active, positionnés à l'extérieur ou à l'intérieur de la carlingue de l'aéronef.

Un tel équipement électronique 4 est encapsulé dans un boîtier, comportant un système de refroidissement par circulation d'un fluide caloporteur dit fluide de refroidissement, qui permet d'évacuer la chaleur produite par le fonctionnement des composants électroniques de l'équipement électronique 4.

Dans le domaine de l'aéronautique sont utilisés notamment les fluides de refroidissement suivants : le Coolanol^{®}, qui est un fluide de refroidissement à base de silicate, et le PAO (polyalpholéfine), à base d'hydrocarbures synthétiques.

Bien entendu, l'invention s'applique avec tout type de fluide de refroidissement, comme décrit plus en détail ci-après.

L'équipement électronique embarqué 4 est avantageusement associé à un système 6 de détection de fuite de fluide de refroidissement, qui permet de détecter la d'émanations gazeuses du fluide de refroidissement.

En d'autres termes, le système 6 de détection de fuite de fluide de refroidissement détecte la présence d'un composé organique volatile émis par le fluide de refroidissement.

Le système 6 de détection de fuite de fluide de refroidissement est particulièrement adapté pour détecter de telles fuites dans les équipements électroniques lorsque l'aéronef est en vol, toute fuite de fluide de refroidissement produisant une émission de gaz associée, en quantité plus ou moins importante en fonction des conditions d'utilisation, notamment de température et de pression.

Par exemple, dans un mode de réalisation, un système 6 de détection de fuite de fluide de refroidissement est placé dans chacun des boîtiers d'équipements électroniques refroidis par un liquide de refroidissement, de manière à détecter une éventuelle fuite de ce liquide de refroidissement.

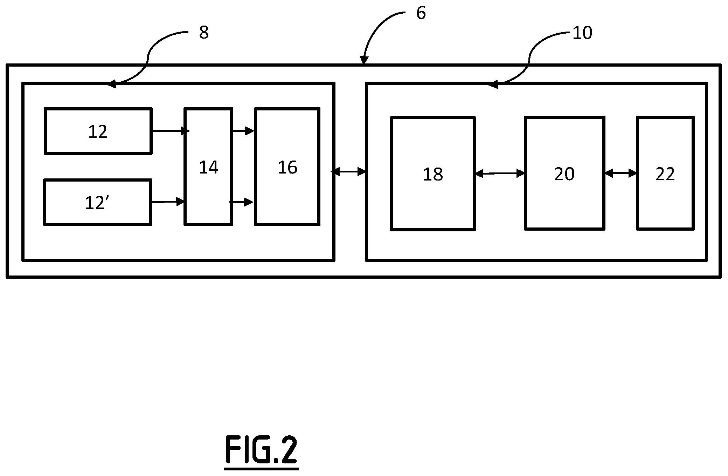

La figure 2 illustre les principaux blocs fonctionnels d'un système de détection de fuite de fluide de refroidissement 6.

Le système 6 comporte un capteur 8 de détection de gaz, connecté à un module électronique de calcul 10.

Avantageusement, le système 6 est adapté pour détecter la présence d'un gaz ou composant organique volatile émis par le fluide de refroidissement, et par conséquent de détecter la présence d'une fuite de fluide de refroidissement en cas de présence d'un tel gaz.

Le capteur 8 comporte un ou plusieurs émetteurs 12 d'ondes électromagnétiques, et plus particulièrement d'ondes optiques, de préférence de longueurs d'onde comprises dans le domaine infrarouge, typiquement entre 780nm et 1mm.

Chaque émetteur 12 est adapté pour émettre dans une plage d'émission centrée sur une longueur d'onde donnée, appelée longueur d'onde d'émission.

La longueur d'onde d'émission est avantageusement choisie en fonction du spectre d'absorption électromagnétique d'un composant organique volatile émis par le fluide de refroidissement.

Dans le mode de réalisation illustré, le capteur 8 comporte deux émetteurs 12, 12' d'ondes électromagnétiques, et plus particulièrement d'ondes optiques, ayant chacun une longueur d'onde d'émission associée.

Par exemple, dans un mode de réalisation, chacun des émetteurs 12, 12' est un dispositif émetteur de faisceaux infrarouges, par exemple une diode électroluminescente LED adaptée à émettre un faisceau infrarouge de longueur d'onde d'émission donnée lorsqu'elle est traversée par un courant électrique.

Le capteur comporte en outre un dispositif de réflexion d'ondes optiques14 et un module photorécepteur 16.

Le module photorécepteur 16 est, de manière connue, un transducteur qui convertit un rayonnement optique incident (ici, il s'agit des ondes optiques réfléchies par le dispositif de réflexion 14) en un signal électrique.

Le signal électrique ainsi obtenu, ou une caractéristique électrique de ce signal (e.g. tension, puissance) est transmis au module électronique de calcul 10.

Ce module 10 comporte par exemple un processeur 18 et une mémoire électronique associée 20.

Le capteur 8 et le module électronique de calcul 10 peuvent être intégrés dans un même dispositif, par exemple dans un même boîtier.

Selon une variante, le module électronique de calcul 10 est un calculateur déporté, par exemple intégré à un système de calcul de bord de l'aéronef, et le capteur 8 communique avec le module électronique de calcul 10 par une liaison de communication, filaire ou sans fil.

Le module électronique de calcul 10 est par exemple un composant logique programmable, tel qu'un FPGA (de l'anglais *Field Programmable Gate Array*), ou un circuit intégré dédié, tel qu'un ASIC (de l'anglais *Application Specific Integrated Circuit*)

La mémoire électronique 20 est en particulier adaptée pour mémoriser des caractéristiques électriques du signal reçu, et par exemple des dates de réception associées.

Le processeur 18 est en particulier adapté pour effectuer des calculs lorsque le module électronique de calcul 10 est mis sous tension, en particulier pour détecter, par exemple en comparant des caractéristiques électriques du signal électrique à des valeurs de seuils, la présence d'un gaz émis par un fluide de refroidissement choisi.

Optionnellement, le module 10 comporte un module de communication 22, adapté pour communiquer avec un autre dispositif électronique non représenté, par exemple en utilisant un protocole de communication filaire ou un protocole de communication sans fil.

Ainsi, la détection de présence de fluide de refroidissement émis est avantageusement signalée à un dispositif distant, par exemple dans le but de générer une alerte à l'intention d'un opérateur.

En variante, la détection de présence de gaz émis par un fluide de refroidissement choisi est mémorisée dans la mémoire électronique 20, par exemple en association avec des valeurs de caractéristiques électriques du signal associées et une date de détection pour traitement ultérieur, par exemple dans une phase de maintenance ultérieure. Les caractéristiques électriques sont par exemple la puissance ou la tension du signal électrique reçu.

Dans un mode de réalisation, un premier émetteur d'ondes optiques 12 a une longueur d'onde d'émission choisie en fonction du spectre d'absorption électromagnétique, et en particulier d'une longueur d'onde absorbée par un composé organique volatil (ou COV) ou gaz émis par le fluide de refroidissement considéré, i.e. le fluide de refroidissement dont une fuite éventuelle est à détecter.

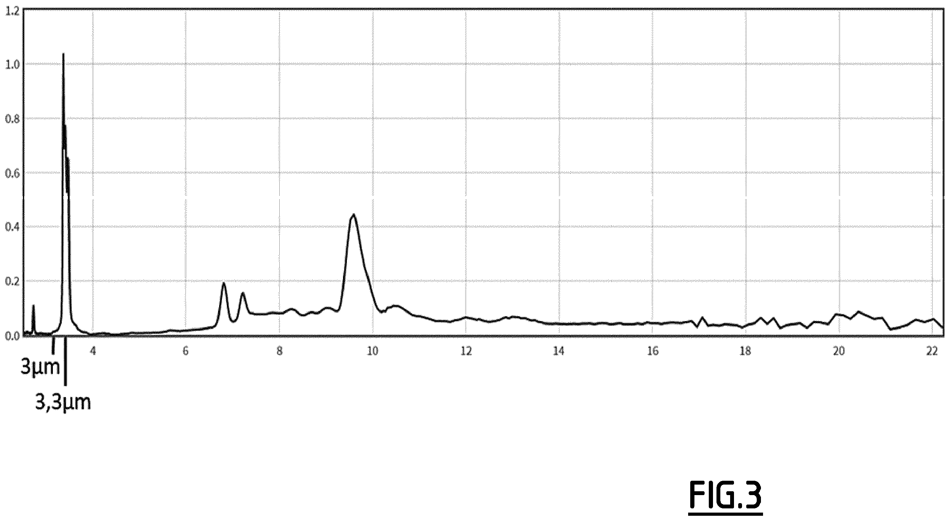

Par exemple, si le fluide de refroidissement est le Coolanol^{®}, un des gaz principalement émis est le 2-éthyl-1-Butanol, dont un exemple de spectre d'absorption dans le domaine infrarouge est illustré à la figure 3.

En effet, la figure 3 illustre un spectre d'absorption du 2-éthyl-1-Butanol, qui est un graphe représentant l'absorbance en ordonnée, en fonction de la longueur d'onde, représentée en abscisse, en micromètres (µm). Comme on peut le constater, le spectre d'absorption comporte un pic d'absorbance principal à environ 3,3µm et un pic secondaire à environ 9,7µm.

Afin de détecter la présence de ce gaz, la longueur d'onde d'émission est choisie égale à la longueur d'onde correspondant au pic d'absorbance principal du 2-éthyl-1-Butanol, par exemple à 3,3µm.

Dans un mode de réalisation, le deuxième émetteur d'ondes optiques 12' est un émetteur d'ondes optiques de référence, de longueur d'onde d'émission de référence, qui n'est pas une longueur d'onde absorbée par le gaz à détecter, par exemple égale à 3µm. Cela permet d'augmenter la sélectivité du capteur.

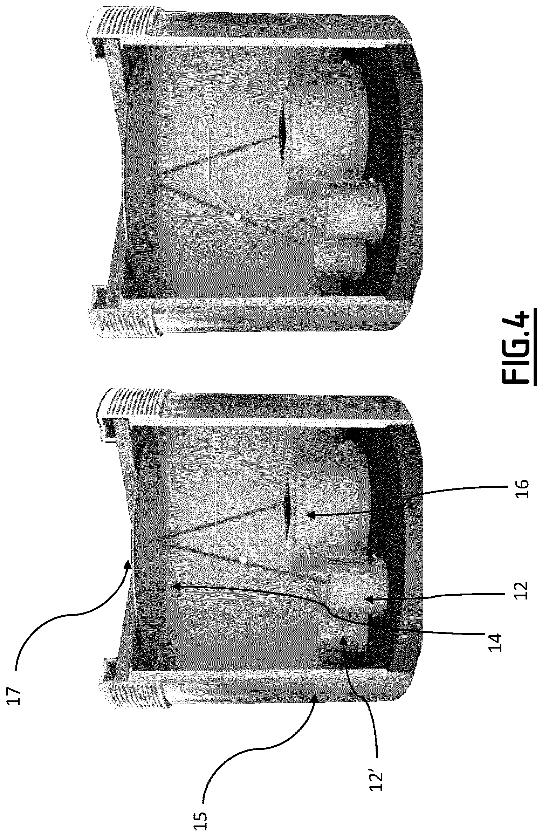

La figure 4 illustre schématiquement un mode de réalisation d'un capteur 8.

Dans ce mode de réalisation, le capteur comprend un conteneur (ou boîtier) 15, par exemple de forme cylindrique.

Le conteneur 15 est de préférence ignifugé et robuste à un niveau de vibrations mécaniques donné.

A l'intérieur du conteneur 15 sont placés les émetteurs 12, 12' d'ondes optiques, le dispositif 14 de réflexion des ondes optiques et le module photorécepteur 16.

Par exemple, l'émetteur 12 émet des ondes optiques de longueur d'onde égale à 3,3µm (longueur d'onde du pic d'absorbance du gaz à détecter) et l'émetteur 12' émet des ondes optiques de longueur d'onde égale à 3 µm (longueur d'onde d'mission de référence).

Par exemple, le conteneur 15 comprend au moins un trou laissant passer l'air ambiant. Dans le mode de réalisation illustré, le conteneur 15 est cylindrique et comprend une plaque 17 de forme circulaire, qui forme un couvercle pour le conteneur 15.

Le dispositif 14 de réflexion des ondes optique, e.g. une surface réfléchissante formant un miroir, est formé sur une première face intérieure de la plaque 17.

En outre, la plaque 17 comprend une série de trous, pratiqués dans son épaisseur, régulièrement espacés sur une couronne périphérique de cette plaque. Les trous formés dans cette plaque laissent passer l'air ambiant, en particulier l'air du boîtier encapsulant l'équipement électronique refroidi par le fluide de refroidissement dont une éventuelle fuite est à détecter.

Bien entendu, il s'agit d'un exemple de réalisation, de multiples variantes étant envisageables, notamment d'autres formes géométriques de conteneur, et d'autres dispositions et répartitions de trous.

Chaque faisceau d'ondes optiques de longueur d'onde d'émission est émis par l'émetteur correspondant, et réfléchi par le dispositif de réflexion 14.

Lorsque le gaz émis par le fluide de refroidissement est présent, le faisceau laser émis par le dispositif 12 d'émission dont la longueur d'onde est égale à la longueur d'onde d'absorbance maximale du gaz (également appelée longueur d'onde absorbée), le faisceau laser est absorbé et la puissance de l'onde optique réfléchie reçue par le module photorécepteur 16 est considérablement diminuée.

La tension du signal électrique en sortie du module photorécepteur 16 est alors diminuée, ce qui permet de détecter la présence d'un gaz absorbant la longueur d'onde d'émission de l'émetteur d'onde optique.

En variante, c'est la puissance de sortie du module photorécepteur qui est utilisée pour la détection de présence de ce gaz.

Lorsque chacun des émetteurs 12, 12' émet des faisceau d'ondes optiques avec la longueur d'onde d'émission qui lui est propre, il est possible par exemple de calculer, par le module électronique de calcul 10, le ratio entre les valeurs de tension de signal électrique obtenue par le photorécepteur est calculé.

Une comparaison de ce ratio à une valeur de seuil de ratio prédéterminée permet de détecter la présence ou non du gaz émis par le fluide de refroidissement considéré. Plus spécifiquement, la comparaison du ratio à une valeur de seuil permet d'éviter de faux positifs dans la détection de présence d'un gaz émis par le fluide de refroidissement considéré.

Le cas dans lequel le fluide de refroidissement est du Coolanol^{®} a été décrit ci-dessus.

Selon une variante, le fluide de refroidissement considéré est du PAO, et le composé organique volatile émis est principalement du décane.

Pour détecter la présence de décane, le spectre d'absorption du décane est obtenu, et de manière analogue à ce qui a été décrit ci-dessus, la longueur d'onde d'un des émetteurs d'ondes optiques est choisie égale à la longueur d'onde correspondant au pic d'absorbance principal du décane.

Selon l'invention, dans le cas d'un fluide de refroidissement qui a un nombre N supérieur ou égal à deux de composants organiques volatiles, chacun ayant un pic d'absorbance de longueur d'onde distincte, il est nécessaire de prévoir N émetteurs d'ondes optiques de longueur d'ondes différentes, de manière à détecter la présence de chacun des composants organiques volatiles émis.

Selon une autre variante, le système de détection 6 utilise un émetteur d'ondes optiques capable d'émettre dans une bande de longueurs d'ondes large donnée, par exemple une bande de longueurs d'onde contenant les N longueurs d'ondes de pics d'absorbance des gaz, et des filtres permettant de sélectionner une longueur d'onde d'émission par commande. En d'autres termes, l'émission d'une longueur d'onde d'émission contenue dans la bande de longueurs d'onde est pilotable via une commande externe.

Selon une autre variante, la sélection d'une ou plusieurs longueurs d'onde est effectuée en réception, par traitement numérique par le module électronique de calcul 10, qui est local ou distant du capteur 8 de détection de gaz.

## Revendications

1. Système de détection de fuite de fluide de refroidissement dans un équipement électronique (4), adapté pour des équipements électroniques (4) embarqués sur des aéronefs, comprenant un capteur (8) de détection de gaz, ledit fluide de refroidissement émettant au moins deux composés volatils, chaque composé organique volatil ayant un spectre d'absorption électromagnétique associé, un pic d'absorbance dudit spectre d'absorption correspondant à une longueur d'onde dite longueur d'onde absorbée par ledit composé organique volatil, ledit capteur (8) de détection de gaz comportant au moins un émetteur (12, 12') d'ondes optiques de longueur d'onde d'émission choisie en fonction d'une longueur d'onde absorbée par le ou un des composés organiques volatils dudit fluide de refroidissement, dans lequel ledit fluide de refroidissement émet un nombre N supérieur ou égal à 2 composés organiques volatils ayant chacun une longueur d'onde absorbée distincte, le capteur (8) de détection de gaz comportant N émetteurs d'ondes optiques, chacun ayant une longueur d'onde d'émission égale à une longueur d'onde absorbée par un desdits composés organiques volatils, de manière à détecter la présence de chacun des composants organiques volatiles émis.

2. Système selon la revendication 1, dans lequel ladite longueur d'onde d'émission est égale à la longueur d'onde absorbée par le ou un des composés organiques volatils émis par le fluide de refroidissement.

3. Système selon l'une des revendications 1 ou 2, dans lequel le capteur (8) de détection de gaz comporte en outre un émetteur (12') d'ondes optiques de référence, ayant une longueur d'onde d'émission distincte de la ou de chaque longueur d'onde absorbée par le ou un des composés organiques volatils émis par le fluide de refroidissement.

4. Système selon l'une des revendications 1 ou 2, dans lequel le capteur (8) de détection de gaz comporte un émetteur d'ondes optiques adapté pour fonctionner dans une bande de longueurs d'ondes, l'émission d'une longueur d'onde d'émission contenue dans ladite bande de longueurs d'onde étant pilotable via une commande externe.

5. Système selon l'une des revendications 1 à 4, dans lequel ledit capteur (8) de détection de gaz comporte en outre un dispositif (14) de réflexion d'ondes optiques et un module photorécepteur (16), le module photorécepteur (16) étant un transducteur configuré pour transformer des ondes optiques réfléchies issues des ondes optiques émises par un desdits émetteurs d'ondes optiques en un signal électrique.

6. Système selon la revendication 5, dans lequel ledit capteur (8) de détection de gaz est inséré dans un conteneur (15) comportant au moins un trou.

7. Système selon la revendication 5 ou 6, comportant en outre un module électronique de calcul (10), configuré pour détecter une présence d'au moins un composé organique volatil dudit fluide de refroidissement en fonction d'une caractéristique électrique dudit signal électrique.

8. Système selon la revendication 7, dans lequel ladite caractéristique électrique est une tension ou une puissance du signal électrique.

9. Système selon l'une des revendications 1 à 8, dans lequel ledit composé organique volatile est du 2-éthyl-1-Butanol ou du décane.

10. Equipement électronique comportant un boîtier encapsulant au moins un composant électronique et un circuit de refroidissement comportant un fluide de refroidissement, **caractérisé en ce qu'**il comporte, à l'intérieur dudit boîtier, un système de détection de fuite de fluide de refroidissement conforme aux revendications 1 à 9.

## Patentansprüche

1. System zur Erkennung von Kühlfluidleckagen in einer elektronischen Ausrüstung (4), angepasst für elektronische Ausrüstungen (4) an Bord von Luftfahrzeugen, umfassend einen Sensor (8) zur Gasdetektion, wobei die Kühlflüssigkeit mindestens zwei flüchtige Verbindungen emittiert, jede flüchtige organische Verbindung ein assoziiertes elektromagnetisches Absorptionsspektrum aufweist, wobei ein Absorptionspeak des Absorptionsspektrums einer Wellenlänge entspricht, die als von der flüchtigen organischen Verbindung absorbierte Wellenlänge bezeichnet wird, der Sensor (8) zur Gasdetektion umfassend mindestens einen Sender (12, 12') für optische Wellen mit einer Emissionswellenlänge, die abhängig von einer Wellenlänge gewählt wird, die von der oder einer der flüchtigen organischen Verbindungen der Kühlflüssigkeit absorbiert wird, wobei die Kühlflüssigkeit eine Anzahl N größer als oder gleich wie 2 flüchtige organische Verbindungen emittiert, wovon jede eine eigene absorbierte Wellenlänge aufweist, der Sensor (8) zur Gasdetektion, der N Lichtwellensender umfasst, die jeweils eine Emissionswellenlänge aufweisen, die gleich wie eine Wellenlänge ist, die von einer der flüchtigen organischen Verbindungen absorbiert wird, um das Vorhandensein jeder der emittierten flüchtigen organischen Komponenten zu erkennen.

2. System nach Anspruch 1, wobei die Emissionswellenlänge gleich wie die Wellenlänge ist, die von der oder einer der flüchtigen organischen Verbindungen absorbiert wird, die von der Kühlflüssigkeit emittiert werden.

3. System nach einem der Ansprüche 1 oder 2, wobei der Sensor (8) zur Gasdetektion ferner einen Sender (12') für optische Referenzwellen umfasst, der eine Emissionswellenlänge aufweist, die sich von der oder jeder Wellenlänge unterscheidet, die von der oder einer der flüchtigen organischen Verbindungen absorbiert wird, die von der Kühlflüssigkeit emittiert werden.

4. System nach einem der Ansprüche 1 oder 2, wobei der Sensor (8) zur Gasdetektion einen Sender für optische Wellen umfasst, der angepasst ist, um in einem Wellenlängenband betrieben zu werden, wobei die Emission einer Emissionswellenlänge, die in dem Wellenlängenband enthalten ist, über eine externe Steuerung steuerbar ist.

5. System nach einem der Ansprüche 1 bis 4, wobei der Sensor (8) zur Gasdetektion ferner eine Vorrichtung (14) zur Reflexion optischer Wellen und ein Fotorezeptormodul (16) umfasst, wobei das Fotorezeptormodul (16) ein Wandler ist, der konfiguriert ist, um reflektierte optische Wellen, die von den optischen Wellen stammen, die von einem der Sender der optischen Wellen emittiert werden, in ein elektrisches Signal umzuwandeln.

6. System nach Anspruch 5, wobei der Sensor (8) zur Gasdetektion in einen Behälter (15) eingesetzt ist, der mindestens ein Loch umfasst.

7. System nach Anspruch 5 oder 6, das ferner ein elektronisches Rechenmodul (10) umfasst, das konfiguriert ist, um ein Vorhandensein von mindestens einer flüchtigen organischen Verbindung der Kühlflüssigkeit abhängig von einem elektrischen Merkmal des genannten elektrischen Signals zu erkennen.

8. System nach Anspruch 7, wobei das elektrische Merkmal eine Spannung oder eine Leistung des elektrischen Signals ist.

9. System nach einem der Ansprüche 1 bis 8, wobei die flüchtige organische Verbindung 2-Ethyl-1-Butanol oder Decan ist.

10. Elektronische Ausrüstung, umfassend ein Gehäuse, das mindestens eine elektronische Komponente einkapselt, und einen Kühlkreislauf, das eine Kühlflüssigkeit umfasst, **dadurch gekennzeichnet, dass** es im Inneren des Gehäuses ein System zur Erkennung von Kühlfluidleckagen gemäß den Ansprüchen 1 bis 9 umfasst.

## Claims

1. A system for detecting leaks of cooling fluid in electronic equipment (4), suitable for electronic equipment (4) on-board aircraft, comprising a gas detection sensor (8), said cooling fluid emitting at least two volatile organic compound, the or each volatile organic compound having an associated radio frequency absorption spectrum, an absorbance peak of said absorption spectrum corresponding to a wavelength called wavelength absorbed by said volatile organic compound, said gas detection sensor (8) including at least one emitter (12, 12') of optical waves with emission wavelength chosen according to a wavelength absorbed by the or one of the volatile organic compounds of said cooling fluid, wherein said cooling fluid emits a number N superior or equal to 2 of volatile organic compounds each having a distinct absorbed wavelength, the gas detection sensor (8) including N optical wave emitters, each having an emission wavelength equal to a wavelength absorbed by one of said volatile organic compounds, so as to detect the presence of each of the emitted volatile organic compounds.

2. The system according to claim 1, wherein said emission wavelength is equal to the wavelength absorbed by the or one of the volatile organic compounds exuding from the cooling fluid.

3. The system according to any of claims 1 or 2, wherein the gas detection sensor (8) further includes a reference optical wave emitter (12'), having an emission wavelength distinct from the or each wavelength absorbed by the or one of the volatile organic compounds exuding from the cooling fluid.

4. The system according to claim 1 or 2, wherein the gas detection sensor (8) includes an optical wave emitter suitable for operating in a wavelength band, the emission of an emission wavelength contained in said wavelength band being controllable via an external control.

5. The system according to any of claims 1 to 4, wherein said gas detection sensor (8) further includes an optical wave reflection device (14) and a photoreceptor module (16), the photoreceptor module (16) being a transducer configured for converting reflected optical waves coming from optical waves emitted by one of said optical wave emitters, into an electrical signal.

6. The system according to claim 5, wherein said gas detection sensor (8) is inserted into a container (15) having at least one hole.

7. The system according to claim 5 or 6, further including an electronic computing module (10) configured for detecting a presence of at least one volatile organic compound of said cooling fluid as a function of an electrical characteristic of said electrical signal.

8. The system according to claim 7, wherein said electrical characteristic is a voltage or a power of the electrical signal.

9. The system according to any of claims 1 to 8, wherein said volatile organic compound is 2-ethyl-1-butanol or decane.

10. An electronic equipment including a casing encapsulating at least one electronic component and a cooling circuit including a cooling fluid, **characterized in that** same includes, inside said casing, a system for detecting leaks of cooling fluid, conforming to claims 1 to 9.
